**Europäisches Patentamt**

**European Patent Office**

**Office européen des brevets**

⑩

(11) Veröffentlichungsnummer: **0 033 390**

**A1**

(12) **EUROPÄISCHE PATENTANMELDUNG**

(21) Anmeldenummer: **80108135.7**

(22) Anmeldetag: **22.12.80**

(51) Int. Cl.³: **H 04 B 1/26**
**H 03 J 5/02, H 04 B 1/04**

(30) Priorität: **27.12.79 US 107593**

(43) Veröffentlichungstag der Anmeldung:
**12.08.81 Patentblatt 81/32**

(84) Benannte Vertragsstaaten:
**AT BE CH DE FR GB IT LI NL SE**

(71) Anmelder: **DEBEG GmbH**
**Behringstrasse 120**
**D-2000 Hamburg 50(DE)**

(72) Erfinder: **Schachtschneider, Gerhard**
**Rodigallee 286**
**D-2000 Hamburg 70(DE)**

(72) Erfinder: **Jones, John Christopher**
**104 Lincoln Drive**
**Laurel Springs New Jersey 08021(US)**

(72) Erfinder: **Besch, Robert**
**1030 Maple Ave.**
**Langhorne Pennsylvania 18047(US)**

(72) Erfinder: **Hunt, Thomas J. Jr.**
**165 McKendimen Road**
**Medford Lakes New Jersey 08033(US)**

(74) Vertreter: **Mehl, Ernst, Dipl.-Ing. et al,**
**Postfach 22 01 76**
**D-8000 München 22(DE)**

㊹ **Radio-Empfangs- und/oder Radio-Sende-Einrichtung.**

㊼ Radioempfänger (12) und/oder Sender (14), der auf eine spezifische Frequenz innerhalb eines Radiofrequenzbereiches oder Spektrumsabgestimmtwerden kann. Der Empfänger (12) und/oder Sender (14) enthalten eine von Hand bedienbare Einrichtung, wie eine Schalttafel oder einen Abstimmknopf, um die spezifische Frequenz einzustellen. Der Empfänger (12) enthält ferner eine Zwischenfrequenzstufe mit einer Anzahl von Zwischenfrequenzfiltern (92, 94, 96) unterschiedlicher Bandbreite und eine Demodulationsstufe, (104) die in Übereinstimmung mit einer Anzahl von Demodulationsarten betreibbar ist. Der Sender (14) enthält eine Modulationsstufe, die in Übereinstimmung mit einer Anzahl von Modulationsarten betreibbar ist. Nach der Erfindung sind Steuermittel vorgesehen, die auf die Einrichtung für die Einstellung der spezifischen Frequenz einwirken und die der automatischen Auswahl eines der Zwischenfrequenzfilter (92, 94, 96) und einer der Demodulationsarten im Empfänger (12) dienen und für die automatische Auswahl der Modulationsart im Sender (14).

./...

EP 0 033 390 A1

FIG. 1

0033390

## Hintergrund der Erfindung

Die Erfindung bezieht sich auf einen Radio-Empfänger und einen Radio-Sender, die entsprechend zum Empfangen und Senden von Radiofrequenzsignalen über einen breiten Frequenzbereich betreibbar sind.

Es ist allgemein bekannt, Sender und Radio-Empfänger für das Senden und Empfangen von Radiofrequenzen so auszubilden, daß sie über einen breiten Frequenzbereich oder ein Spektrum brauchbar sind. Derartige Radioeinrichtungen sind für die Verarbeitung von Übertragungen in einer Vielzahl von Radio-Frequenzbändern geeignet, d. h. Frequenzbändern, die einer besonderen Modulationsart zugeordnet sind, so wie der tonlosen Trägertelegrafie (CW), der Amplitudenmodulation (AM), der Einseitenbandmodulation (SSB) und der Frequenzumtastung (FSK). Ein typischer Radio-Empfänger dieser Art für den Seefunkgebrauch überdeckt einen Frequenzbereich von 10 kHz bis 30 MHz, ein typischer Seefunk- bzw. Marindesender überdeckt einen Frequenzbereich von 1,605 bis 30 MHz.

Abhängig von der Anzahl der Modulationsarten, die vom Durchstimmbereich der Radioeinrichtung erfaßt wird, kann deren Bedienung aufwendig und schwierig sein. Wenn beispielsweise der die Einrichtung Bedienende eine zu empfangende Frequenz auswählt und einstellt, muß er außerdem eine Reihe anderer Empfängerparameter auswählen und einstellen wie die Demodulationsart, die bei der spezifischen Frequenz anzuwenden ist, die richtige Zwischenfrequenz-Bandbreite, die dieser Demodulationsart entspricht und das geeignete Radio-Frequenzband, das durch die Eingangsfilter des Empfängers für die spezielle zu empfangende Frequenz bestimmt ist. Wenn der Empfangs-Frequenzbereich relativ breit ist, wird die Wahl und die Korrelation der verschiedenen Parameter eine schwierige Aufgabe. Aus diesem Grunde ist im allgemeinen ein erfahrenes Bedienungspersonal notwendig.

Zusammenfassung der Erfindung

Ein Gegenstand der Erfindung ist eine Radio-Frequenzeinrichtung (ein Empfänger und Sender), die für den Betrieb in einem relativ breiten Spektrum von Radio-Frequenzen geeignet ist, in dem unterschiedliche Modulationsarten üblich sind.

Dieser Gegenstand und weitere Gegenstände ergeben sich aus der nachstehenden Diskussion und werden nach der Erfindung dadurch erreicht, daß ein Steuerelement angeordnet wird, das auf die von Hand bedienbare Einrichtung wie eine Schalttafel oder einen Abstimmknopf anspricht, welche der Einstellung einer spezifischen Frequenz dient. Dieses Steuerelement dient der automatischen Auswahl eines Zwischenfrequenzfilters und einer der Demodulationsarten im Empfänger und der automatischen Auswahl der Modulationsart im Sender.

In einer bevorzugten Ausführungsform der Erfindung umfaßt das Steuerelement einen oder mehrere programmierbare Mikroprozessoren, welche ein Steuerregister mit den Steuerdaten versehen. Die automatische Auswahl wird durch in vorgeschriebenen Bit-Positionen in dieses Register eingefügte Befehle in Form wenigstens eines Wortes in digitaler Schreibweise aus Einsen und Nullen erreicht.

Die Erfindung sieht somit eine automatische Auswahl der Empfänger- und Sender-Parameter in Abhängigkeit von der Auswahl der spezifischen Empfangs- und Sendefrequenz vor. Es ist somit für den Bedienenden lediglich notwendig, eine Frequenz zu wissen und zu spezifizieren, auf welcher er Senden oder Empfangen will. Diese Frequenz kann dem Bedienenden aus dem Gedächtnis bekannt sein oder kann einem Handbuch entnommen werden, in dem die entsprechenden Frequenzen angegeben sind. Die Einfach-

heit der Bedienung, die durch die Erfindung erreicht wird, macht es somit praktisch jedem möglich, den Empfänger und/oder den Sender zu bedienen, unabhängig davon, ob Betriebserfahrung vorliegt oder nicht.

Ein typischer Radio-Empfänger nach den Grundzügen der Erfindung kann einen Frequenzbereich von etwa 10 kHz bis 30 MHz haben. Ein solcher Empfänger kann Zwischenfrequenzfilter mit großer, mittlerer, schmaler und sehr schmaler Zwischenfrequenz-Bandbreite haben. Die Demodulationsstufe des Empfängers kann so ausgebildet sein, daß sie die Modulationsarten A1, A2, A2H, A3H, A3J und F1 verarbeiten kann. Ein typischer Radio-Sender, der nach den Grundzügen der Erfindung ausgebildet ist, kann einen Frequenzbereich von etwa 1,605 bis etwa 30 MHz haben und für das Senden in einer der Modulationsarten A1, A2H, A3H, A3J und AJ7 geeignet eingerichtet sein.

Die Modulations- und Demodulationsarten, auf die vorstehend Bezug genommen ist, sind die international standardisierten Bezeichnungen für die verschiedenen Sendearten. Die Betriebsart A1 ist die Dauerstrichsendung (CW), d. h. ein Träger, der nur ein- und ausgeschaltet wird. Die Betriebsart A2H ist eine Amplitudenmodulation durch Niederfrequenz, die bei Einseitenband-(SSB) Telegrafie benutzt wird, wenn der gesamte Träger durch Tasttöne moduliert wird. Die A3H-Betriebsart ist die Amplitudenmodulation eines Signals durch ein Audiosignal, wie sie bei der Einseitenband-Telegrafie mit vollem Träger benutzt wird. Die A3J-Betriebsart ist eine Einseitenbandmodulation (SSB) mit einem Radiosignal und unterdrücktem Träger. Die F1-Betriebsart ist eine Telegrafieübertragung durch Frequenzumtastung. Die A7J-Betriebsart simuliert die Betriebsart F1 durch Einseitenbandübertragung eines umgetasteten Audiosignals.

Nach einem besonderen Merkmal der Erfindung enthält der Radioempfänger eine Abstimmeinrichtung, die ebenfalls durch Mikroprozessoren gesteuert ist. Die Abstimmeinrichtung enthält einen Antenneneingang für den Empfang eines Radiofrequenzsignals, einen Frequenz-Synthesizer für die Erzeugung eines gesteuerten örtlichen Oszillatorsignals und eine Mischstufe, der das örtliche Oszillatorsignal und das Radiofrequenzsignal zugeführt werden und die der Erzeugung eines Summen- oder Differenzsignals dient, welches der Zwischenfrequenzstufe des Empfängers zugeführt wird. In dieser Einrichtung wird die Abstimmfrequenz durch geeignete Auswahl des örtlichen Oszillatorsignals eingestellt. Der erwähnte Mikroprozessor dient der Auswahl der örtlichen Frequenz in Abhängigkeit von der Frequenz, die der Bedienende festlegt.

Gemäß einem weiteren Gegenstand der Erfindung umfaßt die Abstimmeinrichtung des Empfängers außerdem eine Vielzahl von Radio-Frequenzfiltern, die zwischen dem Antenneneingang und der Mischstufe eingeschaltet sind. Der Mikroprozessor ist ferner in der Weise hierbei angewendet, daß er eines dieser Radio-Frequenzfilter in Abhängigkeit von der spezifischen Frequenz auswählt. Die Radio-Frequenzfilter können ein Tiefpaßfilter, ein oder mehrere Bandpaßfilter und ein Hochpaßfilter umfassen. Zusätzlich oder alternativ hierzu können die Radio-Frequenzfilter eine Anzahl abstimmbarer LC-Resonanzkreise, die auch als "Vorselektion" bezeichnet werden können, enthalten, von denen jeder in der Lage ist, ein bestimmtes Frequenzband durchzulassen.

Gemäß einem weiteren Gegenstand der Erfindung kann der Empfänger eine von Hand bedienbare Steuereinrichtung enthalten, wie einen Schalterpfad, die der manuellen Auswahl eines der Zwischenfrequenzfilter, einer der Demodulationsarten und/oder eines der Radiofrequenzfilter dient. Solch eine von Hand bedienbare Steuereinrichtung, welche sich bei der Benutzung über die automatische Steuerung hinwegsetzt, erlaubt dem die Radioeinrichtung Bedienenden auch einen unkonventionellen oder einen neu zugeordneten Parameter einzustellen, d. h. einen Parameter oder mehrere Parameter, die bislang nicht in der automatischen Steuerung programmiert waren. Zusätzlich kann die manuelle betätigbare Steuereinrichtung dazu benutzt werden, den Empfänger auch dann zu steuern, wenn die automatische Steuerung für bestimmte aber nicht alle Frequenzen innerhalb des Radiofrequenzbereiches wirksam ist.

Nach einem weiteren Gegenstand der Erfindung umfaßt der Frequenz-Synthesizer des Empfängers einen Referenzoszillator zur Erzeugung eines Festfrequenzsignals und eine oder mehrere Phasenregeschleifen für die Erzeugung von Signalen mit einer gesteuerten Frequenz. Die Phasenregelschleifen umfassen steuerbare und fest eingestellte Frequenzvervielfacher und/oder Frequenzteiler für die Vervielfachung und/oder Teilung der Phasenregelschleifensignale mit einem vorgeschriebenen Vervielfachungsfaktor bzw. Teilerwert. Das Steuerelement ist dabei an den Vervielfacher oder Teiler für die Auswahl des vorgeschriebenen Faktors bzw. Teilers angeschlossen und bestimmt somit die gesteuerte Frequenz.

Die Modulationsart des Senders kann automatisch in ähnlicher Weise wie für die Zwischenfrequenz-Bandbreite und die Demodulationsart im Empfänger ausgewählt werden. Im besonderen kann ein Mikroprozessor als Steuerelement benutzt werden und die Auswahl sowohl der gesteuerten örtlichen Frequenz als auch der Modulationsart in Übereinstimmung mit der durch den Betreibenden spezifizierten Frequenz vornehmen. Ebenso wie der Empfänger kann auch der Sender eine manuell bedienbare Steuereinrichtung für die manuelle Auswahl der Modulationsart enthalten, die gegenüber der automatischen Steuerung bei manueller Bedienung bevorrechtigt ist.

Kurze Beschreibung der Zeichnungen

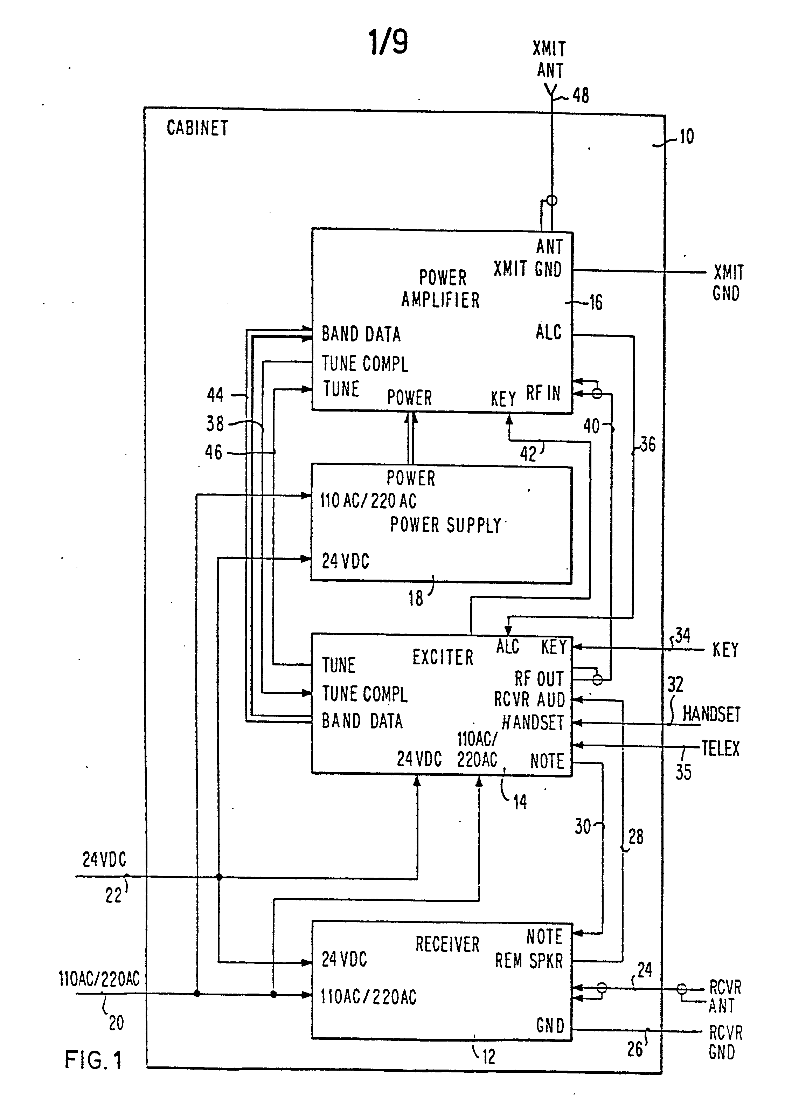

Fig. 1    zeigt ein Blockschaltbild einer Radio-Empfangs-
          und Sendestation nach einer bevorzugten Ausführungsform der Erfindung,

Fig. 2A
und 2B    zeigen ein Blockschaltbild eines Empfängers
          nach Fig. 1,

Fig. 3    zeigt ein Blockschaltbild    von in einem
          Empfänger nach Fig. 2 gesteuerten Teilen,

Fig. 4    ist ein Blockschaltbild des Mikroprozessor-
          Steuersystems des Empfängers nach Fig. 2,

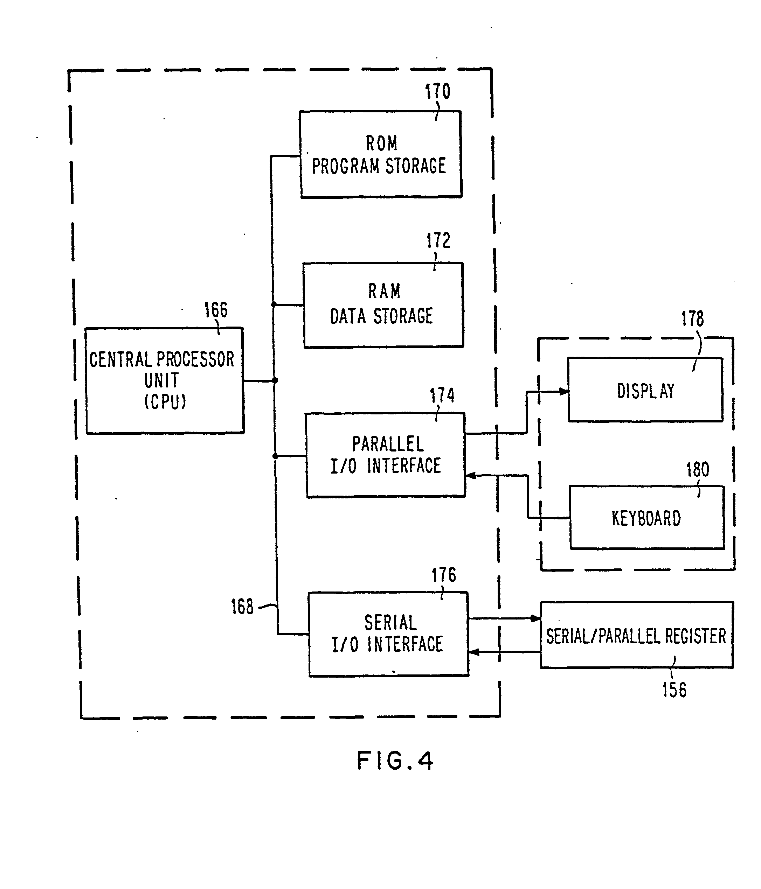

Fig. 5
6A, 6B
und 6C    sind Flußdiagramme für das Steuerprogramm des
          Mikroprozessor-Steuersystems nach Fig. 4
          und

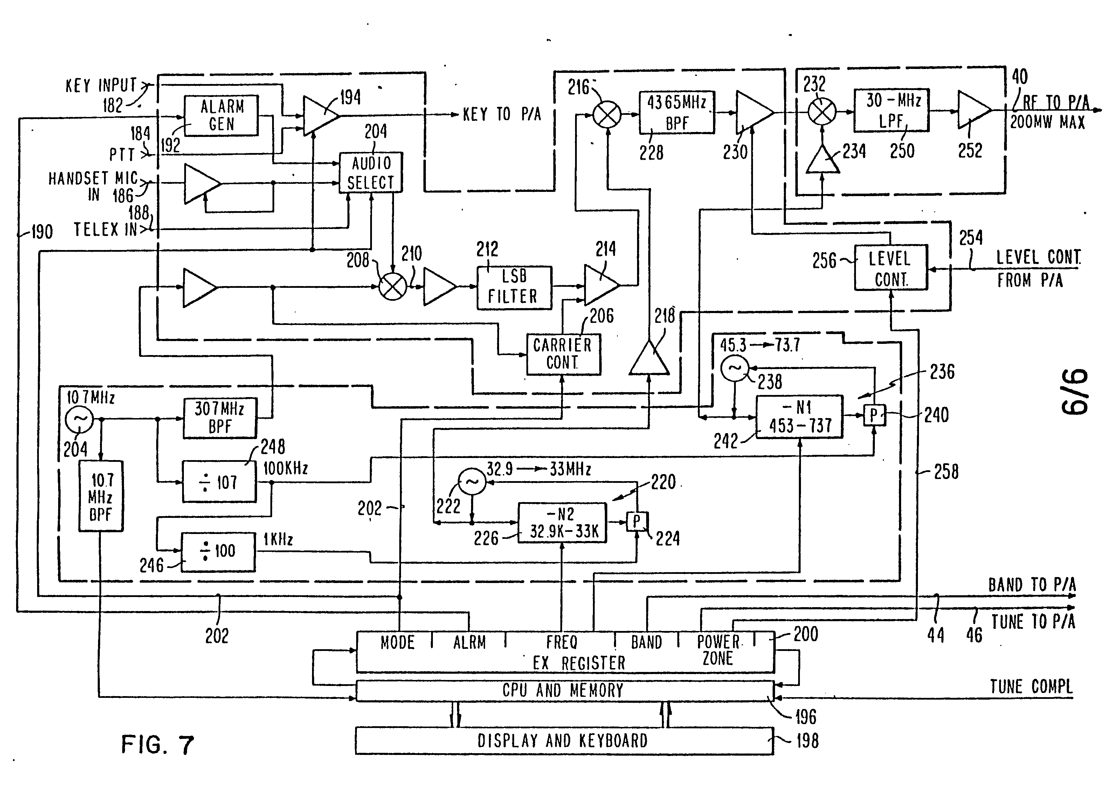

Fig. 7    zeigt ein Blockschaltbild des Steuerteils in
          einem Sender nach Fig. 1.

Beschreibung von bevorzugten Ausführungsformen

Bevorzugte Ausführungsformen der Erfindung werden nachstehend unter Bezugnahme auf einzelne der Zeichnungsfiguren beschrieben. Gleichartige Elemente in den einzelnen Figuren wurden mit den gleichen Bezugszeichen versehen.

Die Fig. 1 zeigt eine Radio-Einrichtung nach der Erfindung. Diese in einem Gehäuse 10 untergebrachte Einrichtung enthält einen Empfänger 12, eine Sender-Steuereinheit 14, einen Senderleistungsverstärker 16 und eine getrennte Stromversorgung 18 für den Senderleistungsverstärker. Der Empfänger 12 und die Steuer- bzw. Anregungsstufe 14 enthalten jeweils ihre eigene interne Stromversorgung, welche als Betriebsspannungen 110 oder 220 Wechselstrom und/oder eine Batterispannung von 24 V an den Leitungen 20 und 22 entsprechend erhalten.

Andere Verbindungen zu dem Empfänger sind der Empfänger-Antenneneingang 24, ein Kontroll-Lautsprecher 28 und Empfängerstillsetzungseingang 30. Der Stillsetzungseingang ist wirksam zur Sperrung des Empfängers während des Sendens, wodurch unerwünschte Überkopplungen vermieden werden. Der Empfänger kann auch mit einem eigenen eingebauten Lautsprecher versehen sein und einem Ausgangsanschluß für Kopfhörer haben.

Die Sender-Steuereinheit 14 empfängt Audiosignale für die Verwendung in einem Handapparat (Kopfhörer) auf Leitung 28 von dem Lautsprecherausgang des Empfängers und empfängt Sprachsignale auf Leitung 32 von einem Handapparat (Mikrofon). Sie erhält ferner ein getastetes Eingangssignal auf Leitung 34 von einer Telegrafietaste oder von einem Telexeingang auf Leitung 35.

0033390

Andere Eingänge der Steuereinheit umfassen eine automatische Pegelsteuerung (ALC) auf Leitung 36 und ein "Abstimmung vollständig"-Signal auf Leitung 38 von dem Senderleistungsverstärker 16.

Die Steuereinheit erzeugt ein Radiofrequenz-Ausgangssignal auf Leitung 40 für die Verstärkung durch den Leistungsverstärker. Da die Verstärkung des Verstärkers variieren kann, wird sein Ausgangssignalpegel auf die Steuereinheit über die automatische Pegelsteuerleitung 36 zurückgeführt, um so den Radiofrequenzausgang derart zu steuern, daß die gesendeten Ausgangsleistungen näherungsweise konstant gehalten wird.

Die in Leitung 34 übertragene Eingangstastung wird in der Steuereinheit verstärkt und direkt zu dem Leistungsverstärker über die Leitung 42 zugeführt, um diesen ein- und auszuschalten.

Die Steuereinheit versorgt zwei weitere Eingänge des Leistungsverstärkers, nämlich den für die Frequenzbanddaten auf Leitung 44 und ein Abstimmsignal auf Leitung 46. Vor einer Sendung auf einer bestimmten Frequenz informiert die Steuereinheit den Leistungsverstärker über die Leitungen 44 über das Frequenzband, in dem die spezifische Frequenz gesendet werden soll. Zu dem Zeitpunkt, in dem die Banddaten auf Leitung 44 vorhanden sind, wird ein Signal auf Leitung 46 erzeugt, das den Leistungsverstärker darüber informiert, daß er sich selbst abstimmen soll. Wenn der Leistungsverstärker abgestimmt ist, gibt er ein Signal auf der "Abstimmung vollzogen"-Leitung 38, so daß die Steuereinheit ein Radiofrequenz-Ausgangssignal erzeugen kann.

Der Sender-Leistungsverstärker 16 erhält das Radiofrequenzsignal von der Steuereinheit auf Leitung 40
und gibt ein verstärktes Abbild dieses Signals an die
Sendeantenne 48. Wenn das Radiofrequenz-Ausgangssignal
in der Steuereinheit 14 moduliert wird, gibt der
Leistungsverstärker dieses Signal entsprechend verstärkt
weiter. Wenn das Radiofrequenzsignal ein Trägersignal
(CW-Signal) ist, folgt der Leistungsverstärker dem
Tasteingang 42, um das Signal ein- und auszuschalten
und zugleich das Signal für die Aussendung dementsprechend zu verstärken.

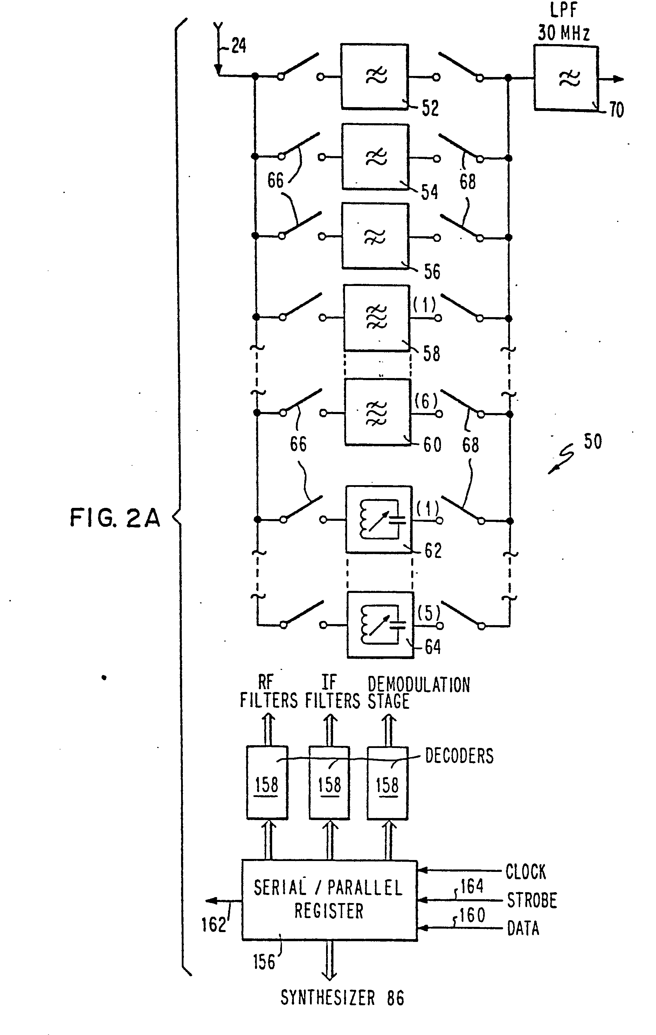

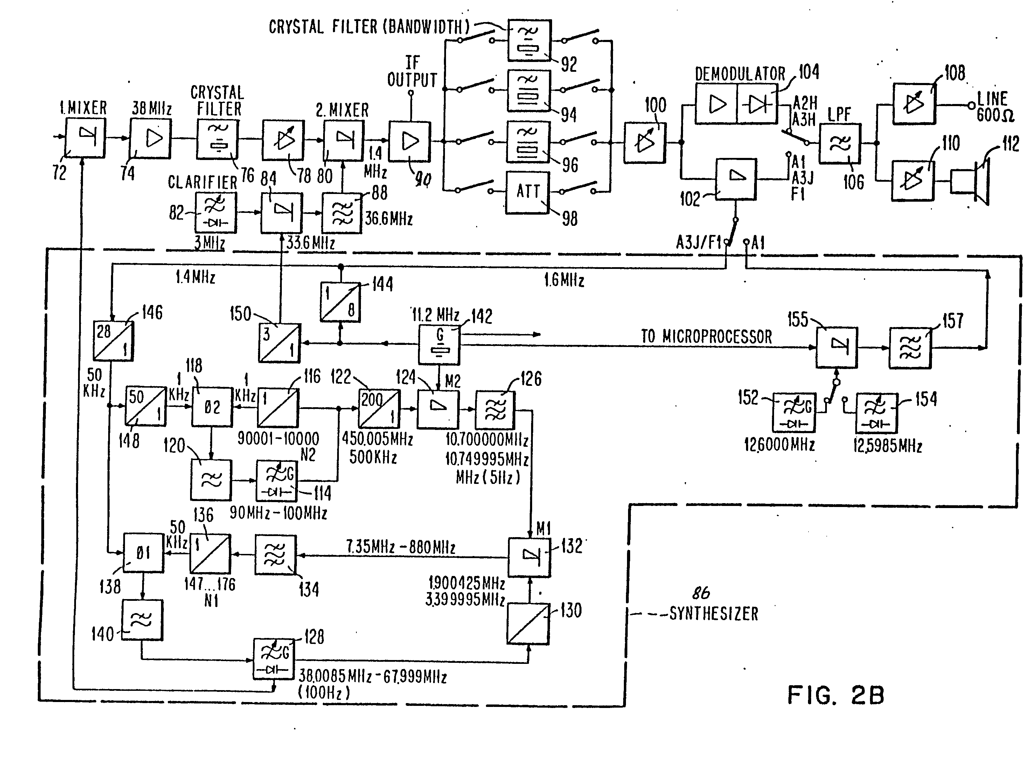

Die Automatik-Besonderheiten der Radioeinrichtung nach
der Fig. 1 werden nachstehend im Detail beschrieben und
zwar unter Bezugnahme auf die übrigen Figuren, von denen
die Figuren 2 bis 6 sich auf den Empfängerteil der Einrichtung beziehen und die Fig. 7 auf die Steuereinheit
des Senders.

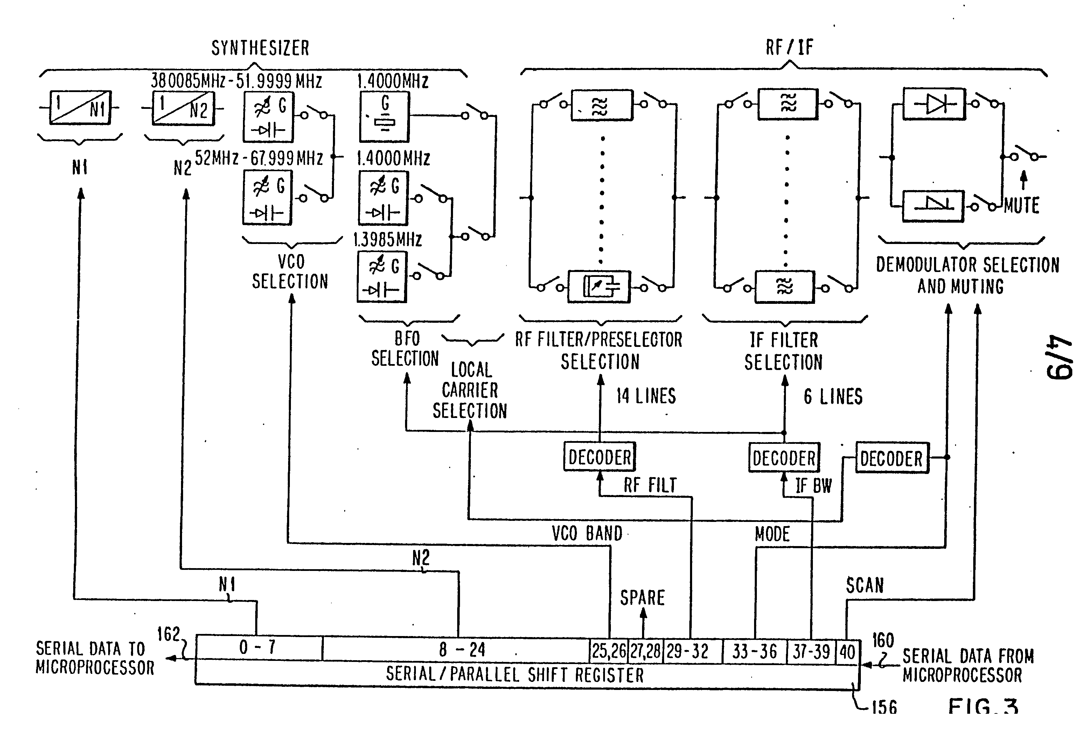

Die zusammengehörigen Fig. 2A und 2B zeigen den Analogsignalteil des Empfängers und die Fig. 3 und 4 das Digitalsystem, das für die Steuerung benutzt wird. In Fig. 2A
führt der Empfänger-Antenneneingang von der Leitung 24
zunächst zu einem Radiofrequenz-Filterabschnitt 50, der
neun fest  abgestimmte Radiofrequenzfilter 52 bis 60
enthält und fünf abstimmbare LC-Kreise, die Vorselektoren genannt werden. Jeweils  eines der vierzehn Filter
wird für den Betrieb ausgewählt und zwar in der nachstehend erwähnten Weise, abhängig von der spezifischen
Empfangsfrequenz, die durch den die Einrichtung Bedienenden festgelegt wurde. Das empfangene Radiofrequenzsignal wird über ein ausgewähltes Radio-Frequenzfilter
geführt, wobei die Auswahl über den entsprechenden Schalter der Eingangsschaltergruppe 66 und den entsprechenden
Schalter der Ausgangsschaltergruppe 68 erfolgt. In der
Zeichnung sind diese Schalter als mechanische Schalter
dargestellt. An deren Stelle werden jedoch in der Praxis bevorzugt Diodenschalter zur entsprechenden Filterauswahl benutzt.

Von den fest abgestimmten Radiofrequenzfiltern sind
die Tiefpaßfilter 52 und 54 und das Hochpaßfilter 56
Breitbandfilter für die Begrenzung und Bandbreite des
empfangenen Frequenzspektrums bei Nicht-Duplex-Betrieb.
Die sechs Bandpaßfilter 58-60 werden zur Unterdrückung
von Ausstrahlungen des Senders bei Duplex-Betrieb verwendet. Die fünf abstimmbaren Vorselektionsfilter 62
bis 64 werden zur Unterdrückung starker Interferenzsignale benutzt oder zur Anpassung des Empfängers an die
Antenne.

Nach dem Durchgang durch ein Radiofrequenzfilter (entweder ein fest abgestimmtes oder ein abstimmbares) wird
das Radiofrequenzsignal einem Tiefpaßfilter mit 30 MHz
Grenzfrequenz zugeführt. Die Grenzfrequenz von 30 MHz
beruht bei diesem Beispiel darauf, daß dies die höchste
Empfangsfrequenz sein soll.

Wie in Fig. 2B dargestellt, wird das Radiofrequenzsignal
vom Ausgang des Tiefpaßfilters 70 einem ersten der
Frequenzumsetzung dienenden Mischer 72 zugeführt, auf
den ein Zwischenfrequenzvorverstärker 74 folgt, um ein
38 MHz-Zwischenfrequenzsignal zu erzeugen. Dieses
38 MHz-Zwischenfrequenzsignal wird über ein Kristallbandfilter 76 und einen Verstärker 78 zu dem einer zweiten Frequenzumsetzung dienenden Mischer 80 geführt.
Ein spannungsgesteuerter Oszillator (VCO) 82 mit einer
Frequenz von 3 MHz dient als Feineinstellung bzw.
"Clarifier" für die manuelle Einstellung des Empfängers
auf den genauen Frequenzwert, der empfangen werden soll.
Das 3 MHz-Signal, das durch den spannungsgesteuerten
Oszillator 82 erzeugt wird, wird in einem Gegentaktmischer 84 mit einem 33,6 MHz-Signal des Frequenz-
Synthesizers 86 des Empfängers gemischt bzw. überlagert.
Das Ausgangssignal des Mischers 84 wird über ein Bandpaßfilter und einen Verstärker 88 zu einem Mischer 80 geführt, der ein 1,4 MHz-Zwischenfrequenzsignal daraus erzeugt.

Das 1,4-Zwischenfrequenzsignal wird einem Verstärker 90 mit zwei Ausgängen zugeführt. Der eine Verstärkerausgang ist an einen Zwischenfrequenz-Ausgangsanschluß an der Rückseite des Empfängergehäuses angeschaltet, der andere Verstärkerausgang führt zu einem der drei Kristallfilter 92, 94 und 96 bzw. einem Dämpfungsglied 98. Die Kristallfilter haben unterschiedliche Bandbreite und zwar sehr schmal, schmal und mittel. Das Dämpfungsglied 98 dient im wesentlichen der Reduzierung des Signalpegels um einen Wert, der dem der Kristallfilter entspricht. Das Dämpfungsglied kann daher, wenn es eingeschaltet ist, wie ein Zwischenfrequenzfilter mit großer Bandbreite angesehen werden.

Die Anschaltung des jeweiligen Zwischenfrequenzfilters an den 1,4 MHz-Ausgang des Verstärkers 90 durch Diodenschalter bewirkt, die vom Empfänger-Steuerungssystem gesteuert werden, das nachstehend noch beschrieben wird.

Nach dem Durchgang durch das entsprechende Zwischenfrequenzfilter wird das 1,4 MHz-Zwischenfrequenzsignal in einem Verstärker 100 verstärkt und einem Produkt-Demodulator 102 und außerdem einem Hüllkurvendemodulator 104 (Envelop-Detektor) im Demodulationsabschnitt des Empfängers zugeführt. Der jeweils zu verwendende Demodulator wird durch Halbleiterschalter ausgewählt und zwar in Übereinstimmung mit der spezifischen Frequenz, die der Bedienende in der nachstehend noch beschriebenen Weise auswählt. Das so gewonnene Audiosignal wird über ein Tiefpaßfilter 106 einem Leitungsverstärker 108 oder über einen Niederfrequenzverstärker 110 mit Lautstärkeregeleung einem Lautsprecher 112 zugeführt.

Der Frequenz-Synthesizer 86 erzeugt alle örtlichen Oszillatorfrequenzen, Träger- und Referenzfrequenzen bzw. Signale, die im Empfänger benötigt werden. Der Synthesizer enthält hierzu zwei programmierbare Phasenregelschleifen. Ein spannungsgesteuerter Oszillator 114 (VCO), eine Teilerschaltung 116 mit einem Teilungsverhältnis 1/N2, ein Phasendetektor 118 und ein Tiefpaßfilter 120 bilden die eine Regelschleife, welche von 90,001 MHz bis 100 MHz in 9,999 einzelnen 1-Kilohertz-Stufen arbeitet. Das Ausgangssignal des spannungsgesteuerten Oszillators (VCO) 114 wird in dem Frequenzteiler 122 um den Teiler 200 geteilt und mit einem 11,2 MHz-Referenzsignal im Mischer 124 überlagert. Das Überlagerungsprodukt wird in einem Bandpaßfilter 126 ausgesiebt, um eine Frequenz im Bereich von 10.700000 MHz bis 10.749995 MHz in 9,999 einzelnen 5-Hertz-Stufen zu erzeugen. Dieses wird in eine die Frequenzen summierende Phasenregelschleife eingespeist, die aus einem spannungsgesteuerten Oszillator (VCO) 128, einem Frequenzteiler 130 mit einem Teilungsverhältnis 1 zu 20, einer Mischstufe 132, einem Bandpaßfilter 134 mit einem Durchlaßbereich von 7,35 MHz bis 8,80 MHz, einem Frequenzteiler 136 mit einem Teilungsverhältnis 1 zu N1, einem Phasendetektor 138 und einem Tiefpaßfilter 140 besteht. Der spannungsgesteuerte Oszillator (VCO) 128 wird im Frequenzbereich von 38.0085 MHz bis 67.999 MHz in 100-Hertz-Stufen betrieben. Das Ausgangssignal des spannungsgesteuerten Oszillators (VCO) 128 dient als veränderbares Oszillatorsignal und speist den ersten Mischer 72 des Empfängers.

Unter der Annahme, daß beide Phasenregelschleifen eingerastet sind, beschreiben die nachstehenden Gleichungen das Betriebsverhalten des Synthesizers.

N1 = Teilerfaktor

N2 = Teilerfaktor

FVCO1 = Frequenz des spannungsgesteuerten Oszillators (VCO) 128

FVCO2 = Frequenz des spannungsgesteuerten Oszillators (VCO) 114

MIX2 out = Ausgangsfrequenz des Mischers 124

$$FVCO2 = N2 \ (1000)$$

$$MIX2 \ out = 11.2 \times 10^6 - \frac{FVCO2}{200}$$

$$MIX2 \ out = 11.2 \times 10^6 - \frac{N2(1000)}{200}$$

$$\frac{FVCO1}{20} = MIX2 \ out - N1 \ (50,000)$$

$$\frac{FVCO1}{20} = 11.2 \times 10^6 - \frac{N2(1000)}{200} - N1(50,000)$$

$$FVCO1 = 224 \times 10^6 - 100 \ N2 - 1 \times 10^6 N1$$

Dadurch wird erreicht, daß bei Veränderung von N1 um den Wert Eins die Frequenz FVCO1 um ein MHz verändert wird, während eine Veränderung von N2 um den Wert Eins die Frequenz FVCO1 um 100 Hz verändert wird.

Die angezeigte Frequenz des Empfängers kann wie folgt beschrieben werden.

F displax = abcde . F    kHz

Die gewünschte Frequenz des spannungsgesteuerten Oszillatros (VCO) 128 ist.

FVCO1 = 38,000.0 kHz + abcde.F kHz,

weil die erste Zwischenfrequenz 38 MHz beträgt und der örtliche Oszillator immer über dem Zwischenfrequenzwert arbeitet.

Die Beziehung von N1 und N2 zur Empfangsfrequenz ist wie folgt:

N1 = 176 - ab

N2 = 100,000 - cdeF.

Damit kann die örtliche Oszillatorfrequenz in Größen der gewünschten Empfangsfrequenz wie folgt beschrieben werden.

$$FVCO1 = 224 \times 10^6 - 100 (1 \times 10^5 - cdeF) - 1 \times 10^6(176-ab).$$

Wenn z. B. die gewünschte Empfangsfrequenz 02182,0 kHz, ab = 0,2,  cdeF = 1820 sind, so ergibt sich:

$$
\begin{aligned}
FVCO1 &= 224 \times 10^6 - 100(1 \times 10^5 - 1820) - 1 \times 10^6(176-02) \\
&= 224 \times 10^6 - 9.818 \times 10^6 - 174 \times 10^6 \\
&= 40.182 \times 10^6 \\
&= 38.000 \times 10^6 + 2.182 \times 10^6.
\end{aligned}
$$

Der Synthesizer erzeugt sowohl alle Referenzfrequenzen für seinen eigenen Bedarf als auch die für den restlichen Teil des Empfängers benötigten Frequenzen. Das Ausgangssignal eines 11,2 MHz-Kristalloszillators 142, der temperaturkompensiert ist, wird einer Teilerschaltung 144 zur Frequenzteilung um den Faktor 8 zugeführt, um ein 1,4 MHz-Signal zu erzeugen, das als örtlicher für die A3J- und die F1-Demodulation benötigt wird.
Dieses 1,4 MHz-Signal wird um den Wert 28 in einem Teiler 146 geteilt, um ein 50 kHz-Signal für die Verwendung
in der Phasenregelschleife zu erhalten, die den spannungsgesteuerten Oszillator (VCO) 128 enthält. Das 50 kHz-
Signal wird weiterhin in der Frequenz um den Wert 50 in
einem Teiler 148 geteilt, um ein 1 kHz-Signal für die Verwendung in der Phasenregelschleife zu erhalten, die
den spannungsgesteuerten Oszillator (VCO) 114 enthält.
Das 11,2 MHz-Oszillator-Ausgangssignal wird um den
Faktor drei in einem Frequenzvervielfacher 150 vervielfacht, um ein Signal mit der Frequenz 33,6 MHz zu erhalten, das zusammen mit der Zwischenfrequenz von
38 MHz zur Erzeugung der 1,4 MHz Zwischenfrequenz im
Ausgang des Mischers 80 dient.

Eines der Ausgangssignale mit einer Frequenz von etwa
12,6 MHz der beiden spannungsgesteuerten Oszillatoren
(VCO) 152 und 154, das manuell am Einstellknopf des Überlagerungsoszillators (BFO) des Empfängers eingestellt
werden kann, wird mit der frequenzstabilen Frequenz
11,2 MHz in einem Mischer 155 gemischt, um ein
variables 1,4 MHz-Überlagerungssignal (BFO-Signal)
für die A1-Demodulation zu gewinnen. Die Summenfrequenz
wird über ein Bandpaßfilter 157 entnommen.

Die beiden Überlagerungsoszillatoren (BFO) bzw. spannungsgesteuerten Oszillatoren (VCO) sind in der Frequenz um 1,5 kHz verschieden. Beispielsweise erzeugt
der Überlagerungsoszillator (BFO) 152 eine Frequenz
von 12,6 MHz, während der Überlagerungsozillator (BFO) 154
eine Frequenz von 12.5985 MHz erzeugt. Der geeignete
Überlagerungsoszillator (BFO) wird automatisch ausgewählt, wenn eine 1,5 kHz Ablage benötigt wird.

Die automatische Steuerung des Empfängers, wie sie in
den Figuren 2A und 2B gezeigt ist, wird durch einen Mikroprozessor bewirkt, der die entsprechenden Daten an ein Serie-Parallel-Schieberegister 156 gibt. Diese Daten werden verwendet, um die geeigneten Radiofrequenzfilter, Zwischenfrequenzfilter, Demodulationsarten und die geeigneten Werte von N1 und N2 im Synthesizer auszuwählen. Die Decoder 158 sind zur erforderlichen Steuerung der Diodenschalter vorgesehen.

Die Fig. 3 zeigt das Serie-Parallel-Register 156, das ein 40 Bit-Wortspeicher sein kann. Die Daten werden seriell in das Register 156 vom Mikroprozessor eingespeist. Wenn 40 Bit eingeschoben sind, sendet der Mikroprozessor die selben Daten ein zweites Mal und vergleicht diese Daten Bit um Bit mit den Daten, die von dem Register über die Leitung 162 zurückgegeben werden. Wenn kein Datenfehler festgestellt wird. d. h. wenn das erste und das zweite 40 Bit-Wort identisch sind, sendet der Mikroprozessor ein Auswertesignal in Leitung 164.

Die Fig. 3 erläutert, wie das 40 Bit-Wort zur Steuerung der verschiedenen Parameter des Empfängers verwendet wird. Acht Bit werden verwendet zur Bestimmung von N1. Sechzehn Bit werden verwendet zur Bestimmung von N2. Zwei Bit bestimmen, welcher von den beiden spannungsgesteuerten Oszillatoren für den spannungsgesteuerten Oszillator 128 eingeschaltet werden. Drei Bit werden in sechs Leitungen für die Auswahl oder die Nichtauswahl des Überlagerungsfrequenz-Oszillators und die Auswahl eines der vier Zwischenfrequenzfilter decodiert. Vier Bit werden in vierzehn Leitungen für die Auswahl der Radiofrequenzfilter (neun Filter und fünf Vorselektoren) decodiert. Vier Bit werden zur Auswahl der Demodulationsart verwendet.

Fig. 4 ist ein Blockschaltbild des Mikroprozessor-Steuersystems, das in dem Empfänger nach den Fig. 2A und 2B angewendet wird. Das System umfaßt einen Mikroprozessor 166 vom Typ 8080A, der auf dem Markt allgemein bekannt und käuflich ist. Der Typ 8080A ist eine vollständige, Acht-Bit-Parallel-Zentralprozessoreinheit (CPU). Die CPU übermittelt Datenspeicher und Peripheradressen und innere Zustandsinformationen über einen Bus 168 zu einem Nur-Auslesespeicher (ROM) 170, einem Speicher mit beliebigen, wahlweisem Zugriff (RAM) 172, einem Parallel-Eingangs/Ausgangs-Zwischenglied (Interface) 174 und einem Serie-Eingang/Ausgang-Zwischenglied (Interface) 176. Das Parallel-Eingang-Zwischenglied 174 überträgt und empfängt Daten jeweils entsprechend von einer digitalen LED-Anzeige 178 und einer Schalttafel 180. Das Serie-Eingang/Ausgang-Zwischenglied 176 gibt und empfängt Daten von dem Serie-Parallel-Schieberegister 156.

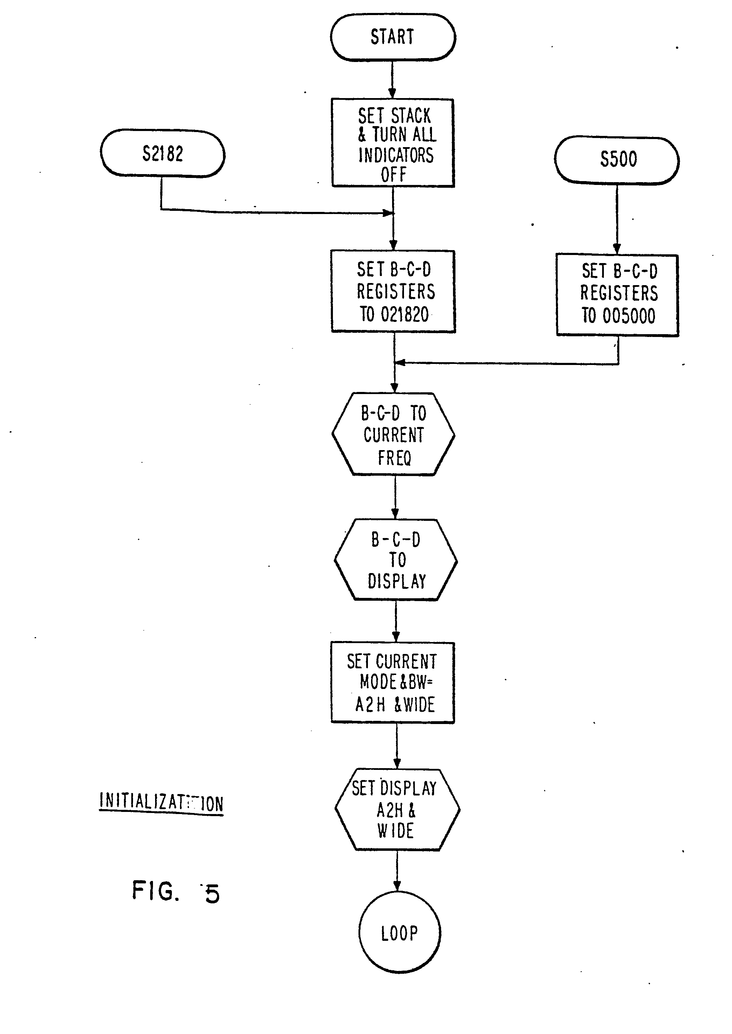

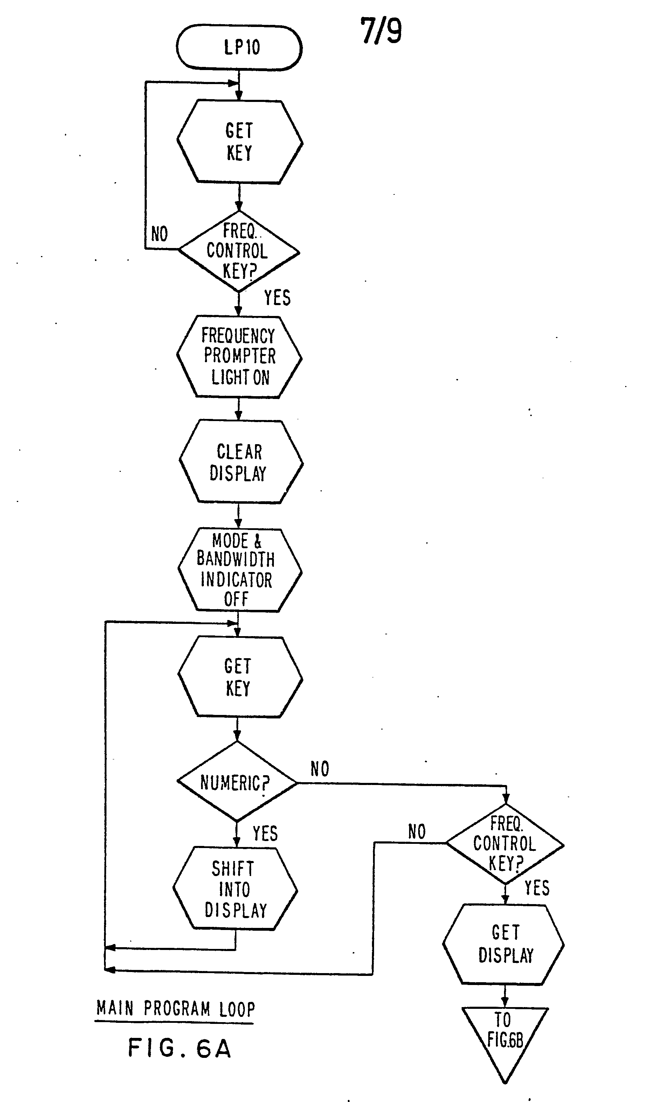

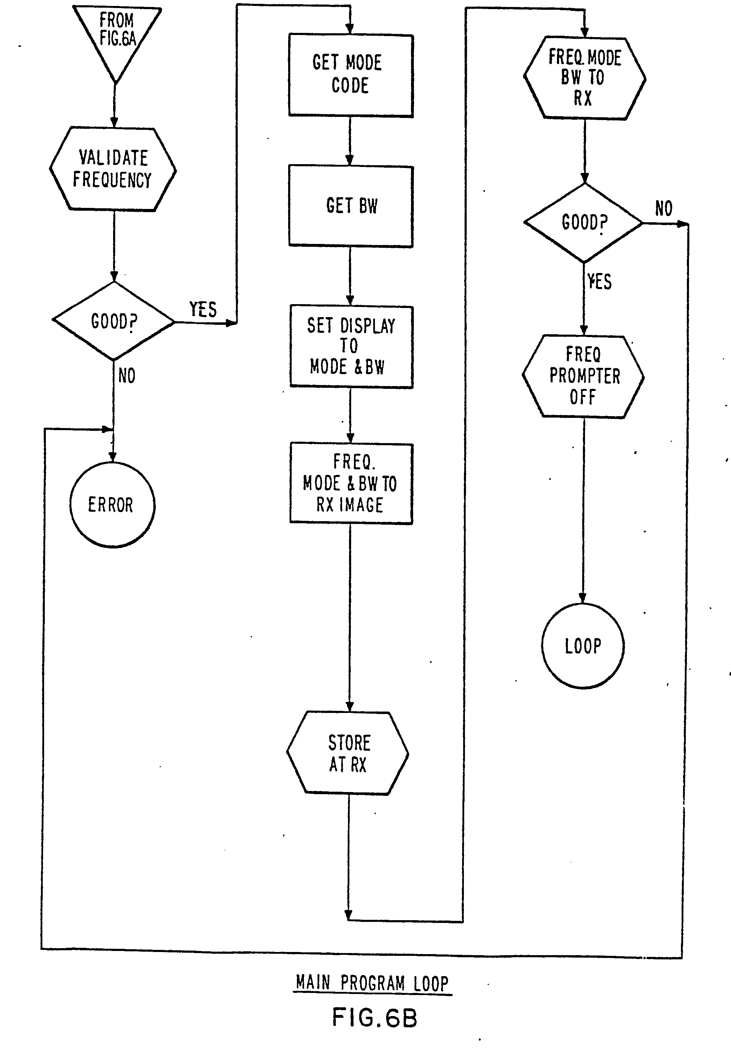

Das Steuersystem, wie es in der Fig. 4 gezeigt ist, arbeitet in der Weise, daß es einen Frequenzwert übernimmt, der von der Schalttafel 180 eingegeben wird und ein entsprechendes 40-Bit-Wort zu dem Schieberegister 156 veranlaßt, um die Steuerung der verschiedenen Parameter des Empfängers durchzuführen. Das Steuerungssystem veranlaßt außerdem, daß die Frequenz an der Anzeige 178 angezeigt wird. Die Fig. 5,6A und 6B sind Flußdiagramme des CPU-Programms, das diese Funktionen ausführt. Obwohl diese Flußdiagramme im wesentlichen aus sich heraus schon verständlich sind, werden sie nachstehend noch kurz beschrieben.

Wenn der Empfänger eingeschaltet wird oder auf eine der 500 kHz- oder 2182 kHz-Notfrequenzen abgestimmt wird, läuft das Programm durch eine Auslösemaßnahme ab. Bei diesem Ablauf wird die Notfrequenz in BCD-Register im CPU eingegeben. BCD bedeutet hierbei "Binary Coded Decimal". Der Inhalt dieser Register wird die erforderliche spezifische Frequenz des Empfängers. Diese Frequenzinformation und auch die über die Ablaufart (Current mode) und die Bandbreite werden zur Anzeigeeinrichtung 178 geführt. Um die eine der

beiden Notfrequenzen zu empfangen, wird die Betriebsart auf A2H und die Zwischenfrequenzfilter-Bandbreite
auf breit gesetzt. Danach geht dieses Programm durch eine
Ablaufschleife, wie sie in den Fig. 6A und 6B gezeigt ist.

Nach diesem Programm wird wiederholt überprüft, ob der
Bedienende den Frequenzsteuerschalter betätigt hat. Der
Frequenzsteuerschalter ist ein Schalter in der Schalttafel, der dem Empfänger mitteilt, daß ein Frequenzwert vorliegt, auf den eingestellt werden soll. Wenn
der Schalter gedrückt wird, wird das Anregungslicht
(Frequency Prompter Light) eingeschaltet und die digitale Anzeige ist betriebsbereit. Die Betriebsart und
die Bandbreite-Anzeigeeinrichtungen werden abgeschaltet
und das Programm wertet die Eingabe der numerischen
Information aus, welche die Frequenz spezifiziert. Nach
der Eingabe der numerischen Information drückt der Bedienende erneut den Frequenzschalter, um die Vollständigkeit der Frequenzeingabe anzuzeigen. Wenn dies
geschehen ist, erhält das Programm die Frequenz, die in
die Anzeigeeinrichtung eingegeben wurde und speichert
sie in dem BCD-Register.

Danach wird, so wie in Fig. 6B gezeigt, die Frequenz
bewertet, um sicherzustellen, daß sie im Bereich der
Frequenzen des Empfängers liegt. Wenn dies der Fall ist,
läuft ein Steuerprogramm für eine Fehlerbestimmung ab
und hält an. Wenn die Frequenz als richtig angenommen
wird, werden die Modulationsart und die Zwischenbandbreite, die durch die Frequenze festgelegt sind, durch
einen Ablaufprozeß erhalten. Danach werden die Betriebsart und die Bandbreite der Anzeigeeinrichtung zugeführt
und das 40 Bit-Steuerwort wird aus der Frequenz-, der
Betriebsart und der Bandbreite-Information erzeugt.

Dieses Steuerwort wird über das Serie-/Parallel-
Register 156 (bezeichnet mit RX) geführt und nach dem Durchlauf bitweise mit dem Vierzig-Bit-Steuerwort verglichen, das vorausgehend durch das Register gelaufen
ist. Wenn kein Fehler festgestellt wird, wird die Frequenzversorgungsspannung abgeschaltet und das Programm
kehrt in seine Ausgangsposition zurück. Wenn die einzelnen Bit, die vom Register 156 erhalten werden, nicht
identisch sind zu denen die gesendet wurden, tritt das
Programm in den Ablauf für die Fehleranzeige ein.

Die Fig. 7 zeigt die Steuereinheit des Senders, die
in ähnlicher Weise durch einen Mikroprozessor gesteuert
wird wie im Empfänger. Die Steuereinheit erhält irgend
eines aus einer Anzahl von Eingangssignalen, das das
zu sendende Signal definiert. Dies kann durch einen
Schaltereingang 182 oder einen Sprechtasteneingang 184
oder einen Handapparat-(Mikrofon)-Eingang 186 oder einen
Telexeingang 188 geschehen. Nach der Aktivierung durch
ein Signal auf der Leitung 190 erzeugt ein Generator 192
einen der international standardisierten Notrufe.

Der Schaltereingang 182 führt über einen Schaltverstärker 194 zu dem Sender-Leistungsverstärker, um den
Leistungsverstärker entsprechend ein- und auszuschalten.

Das Steuersystem 196 der Steuereinheit enthält eine CPU
und einen Speicher. die Struktur dieses Steuersystems
kann identisch zu der in Fig. 4 für den Empfänger gezeigten sein. Die CPU erzeugt und empfängt Daten entsprechend von der Anzeige und der Schalttafel 198. Sie
führt ein entsprechendes Ausgangswort in serieller Form
an ein Register 200 der Steuereinheit für die Steuerung
der Steuereinheit. Dieses Register dient dem gleichen
Zweck wie das Serie-Parallel-Schieberegister 156 des
Empfängers.

Wenn die zu sendende Frequenz in die Schalttafel der
Steuereinheit eingegeben wird, wählt die CPU die Betriebsart, stellt fest, ob ein Notruf erzeugt werden soll und wählt das für die Sendung zu benutzende Band für den Leistungsverstärker aus. Ein Steuerwort, das diese Information beinhaltet, wird in das Register 200 der Steuereinheit übergeben und Signale werden in dem geeigneten Zeitpunkt zu der Steuereinheit und dem Leistungsverstärker weitergegeben.

Betriebsartensignale, die auf der Leitung 202 auftreten, werden einem Niederfrequenz-Selektor 205, dem Schaltverstärker 194 und einer Trägersteuerung 206 zugeführt. Abhängig von der ausgewählten Betriebsart wird dieses Schalteingangssignal über den Verstärker 194 zu dem Leistungsverstärker oder einem der anderen Eingänge, die durch die Einrichtung 204 ausgewählt wurden, gegeben und das entsprechende Signal geht zu einem ersten Mischer 208. Dieses Signal moduliert einen 10.7 MHz-Träger zur Erzeugung eines Zweiseitenbandsignals mit unterdrücktem Trägersignal auf der Leitung 210. Dieses Signal wird verstärkt und geht über ein Filter 212 für das untere Seitenband, um das obere Seitenband zu unterdrücken und wird dann einem Mischerverstärker 214 zugeführt, der das untere Seitenband mit dem unterdrückten Trägersignal mit dem 10.7 MHz-Träger wieder zusammenfügt. Abhängig von der Betriebsart wird dieser Träger bedarfsweise durch die Trägersteuerung 206 zu dem Verstärker 214 geführt.

Das Ausgangssignal des Verstärkers 214 wird zu einem zweiten Frequenzumsetzer 216 geführt, der das Oszillatorsignal von dem Verstärker 218 im Frequenzbereich von 32,9 bis 33 MHz erhält. Dieses Signal wird in 100 Hz-Stufen durch eine erste Phasenregelschleife 220 ausgewählt, die einen spannungsgesteuerten Oszillator (VCO) 222, einen Phasenselektor 224 und eine Teilerschaltung mit dem Teilungsverhältnis $1/N2$ enthält. $N2$ ist eine Zahl, die durch das Steuereinheit-Register ausgewählt wird und zwar zwischen 32.9 K und 33 K, d. h. 32,900; 32,901; 32,902 ... 33,000.

Das Ausgangssignal des zweiten Mischers 216 wird über ein 43.65 MHz-Bandpaßfilter 228 und einer spannungsgesteuerten Verstärker 230 zu einem dritten Mischer 232 geführt. Dieser Mischer  erhält ein Signal mit einer Frequenz im Bereich von 45,3 bis 73,7 MHz über einen Verstärker 234 und eine zweite Phasenregelschleife 236. Diese zweite Phasenregelschleife enthält einen spannungsgesteuerten Oszillator (VCO) 238, einen Phasendetektor 240 und eine Frequenzteilerschaltung 242 mit dem Teilungsverhältnis 1:N1. Die zwei Phasenregelschleifen 220 und 236 erhalten 1 kHz- und 100 kHz-Signale entsprechend von dem Referenzoszillator 244 und den Teilern 246 und 248.

Das Ausgangssignal des dritten Mischers 232 wird über ein 30 MHz-Tiefpaßfilter 250 und einen Verstärker 252 zu dem Sender-Leistungsverstärker geführt. Das Pegel-Kontrolleingangssignal 254 vom Leistungsverstärker wird in einer Pegel-Steuerschaltung 256 in eine zur Anwendung in dem spannungsgesteuerten Verstärker 230 geeignete Spannung umgesetzt. Das Ausgangssignal der Pegel-Steuerschaltung 256 kann manuell von der Schalttafel 198, der CPU 196 und dem Steuereinheit-Register 200 eingestellt werden, das ein Digitalsignal für die Pegelkontrolle über die Leitung 258 gibt.

Der vorstehend beschriebene Radio-Empfänger und Radio-Sender stellen bevorzugte Ausführungsformen der Erfindung dar. Es ist jedoch darauf hinzuweisen, daß dies keine Beschränkung der Erfindung auf diese Ausführungsbeispiele darstellen soll.

Als Werte für die verschiedenen Bandbreiten können folgende genommen werden. Große Bandbreite 6 kHz, mittlere Bandbreite 3 oder 4 kHz, schmale Bandbreite 1 kHz und sehr schmale Bandbreite 200 Hz. Die Kristallfilter erlauben in besonders einfacher Weise die Frequenz- und Bandbreitewerte einzuschalten. Elektromechanische Filter mit metallischen Resonatoren sind ebenso wie Filter auf digitaler Basis, die alle allgemein bekannt sind, gut anwendbar. Bei den hohen Bandbreitewerten sind auch Spulenfilter anwendbar.

In manchen Fällen kann es wünschenswert sein, die automatische Betriebsart- und Bandbreitesteuerung durch eine manuelle Steuerung zu ersetzen. Beispielsweise kann dies auftreten, wenn sich internationale Standards ändern oder wenn die automatische Steuerung nur für bestimmte Frequenzen und nicht für alle Abstimmfrequenzen des Empfängers wirksam ist. Die manuelle Steuerung kann in der Weise vollzogen werden, daß getrennte Betriebsarten- und Bandbreitenschalter an der Schalttafel bzw. Frontplatte des Gerätes vorgesehen werden. Diese Schalter veranlassen dann, daß die so ausgewählte Betriebsart und/oder Bandbreite in dem Mikroprozessorsteuersystem eingespeichert werden. Nach der Einspeicherung dieser Werte gibt dann der Mikroprozessor ein neues 40-Bit-Steuerwort ab und überführt dieses Wort in das Serien/Parallel-Register 156 in der gleichen Weise, wie es anhand der Figuren 5 bis 6b erläutert ist.

Die Fig. 6a illustriert, wie dieser Ablauf den manuellen Bevorrechtigungsvorgang erfaßt und durchführt. Wie gezeigt, werden bei diesem Arbeitsablauf die entsprechenden Schalter an der Frontplatte bzw. der Schalttafel wiederholt abgetastet, um festzustellen, ob bzw. wann ein Frequenzsteuerschalter, ein Betriebsartenschalter oder ein Bandbreitenschalter manuell ausgewählt bzw. betätigt würden. Wenn einer dieser Schalter
betätigt wurde, geht der weitere Ablauf entsprechend
der Ablaufvorschrift für diesen Schalter und kehrt
dann an den Anfang des Hauptprogramms bzw. Hauptarbeitsablaufes zurück.

Vor allem zu den Figuren 5, 6a und 6b ist noch zu erwähnen, daß immer dann, wenn der Ausdruck "Schleife"
bzw. "Loop" erscheint, der Arbeitsablauf bzw. die die
Programmsteuerung auf den Anfang des Hauptarbeitsablaufes bzw. des Hauptprogramms zurückgesetzt wird bzw.
zurückkehrt. Dieser Anfang ist in der Fig. 6a mit
Schleifenanfang bzw. Loopstart bezeichnet.

28 Patentansprüche
 9 Figuren

Patentansprüche

1. Radio-Empfänger mit einer Einrichtung zur Einstellung einer im Durchstimmbereich gelegenen spezifischen Empfangsfrequenz, die manuell betätigbare Einstellmittel für die Eingabe des Wertes der spezifischen Frequenz enthält, des weiteren mit einem Zwischenfrequenzteil, der mehrere Zwischenfrequenz-Bandfilter unterschiedlicher Bandbreite enthält, und des weiteren mit einer Demodulationsstufe für unterschiedliche Demodulationsarten, d a d u r c h   g e k e n n z e i c h n e t , daß eine Steuereinrichtung (erste Steuermittel) vorgesehen ist, die auf die Einstellmittel ansprechen und eines der Zwischenfrequenz-Bandfilter und eine der Demodulationsarten für den Betrieb wirksam schalten, derart, daß die wirksam geschalteten Teile in der Bandbreite bzw. der Demodulationsart den bei der spezifischen Frequenz erforderlichen ensprechen

2. Radio-Empfänger nach Anspruch 1,   d a d u r c h   g e k e n n z e i c h n e t ,   daß die Einstelleinrichtung zweite Steuermittel enthält, die auf die Einstelleinrichtung für die Abstimmung des Empfängers auf die spezifische Frequenz ansprechen.

3. Radio-Empfänger nach Anspruch 2,   d a d u r c h   g e k e n n z e i c h n e t ,   daß die ersten und die zweiten Steuermittel einen im Time-Sharing-Betrieb arbeitenden Mikroprozessor enthalten.

4. Radio-Empfänger nach Anspruch 2,   d a d u r c h   g e k e n n z e i c h n e t ,   daß die Abstimmeinrichtung folgende Mittel umfaßt:
   a) einen Antenneneingang für den Empfang eines Radiofrequenzsignals
   b) einen Frequenz-Synthesizer für die Erzeugung eines gesteuerten örtlichen Frequenzsignals

c) einen ersten Mischer, der das besagte örtliche Frequenzsignal und das besagte Radiofrequenzsignal erhält, um daraus ein erstes Summen- oder Differenzsignal zu gewinnen

d) die zweiten Steuermittel sind an den Frequenz-Synthesizer angeschaltet, um die örtliche Frequenz in Übereinstimmung mit der spezifischen Frequenz auszuwählen.

5. Radio-Empfänger nach Anspruch 4, bei dem die Abstimmeinrichtung ferner eine Vielzahl von Radiofrequenz-Filtern umfaßt, die zwischen dem Antenneneingang und dem ersten Mischer eingeschaltet sind und bei dem die zweiten Steuermittel auf die Einstellmittel in der Weise einwirken, daß das für die spezifische Frequenz passende Radiofrequenzfilter ausgewählt wird.

6. Radio-Empfänger nach Anspruch 5, d a d u r c h g e k e n n z e i c h n e t , daß die Radiofrequenzfilter ein Tiefpaßfilter, zumindest ein Bandpaßfilter und ein Hochpaßfilter umfassen.

7. Radio-Empfänger nach Anspruch 5, bei dem die Radiofrequenzfilter eine Vielzahl abstimmbarer Vorselektionskreise enthält für den Durchlaß eines abgestimmten Bands von Frequenzen.

8. Radio-Empfänger nach Anspruch 1, d a d u r c h g e k e n n z e i c h n e t , daß die Bandbreiten der Zwischenfrequenzfilter ein schmalbandiges, ein mittelbreites und ein breites Zwischenfrequenzbandfilter enthalten.

9. Radio-Empfänger nach Anspruch 8, d a d u r c h g e k e n n z e i c h n e t , daß die Zwischenfrequenz-Bandfilter außerdem ein sehr schmales Zwischenfrequenz-Bandfilter umfassen.

10. Radio-Empfänger nach Anspruch 1, d a d u r c h
g e k e n n z e i c h n e t ,  daß die Demodulationsstufe alle Betriebsarten bzw. Demodulationsarten der
üblichen Radiosendungen innerhalb des Durchstimmbereichs
des Empfängers umfaßt.

11. Radio-Empfänger nach Anspruch 10, d a d u r c h
g e k e n n z e i c h n e t ,  daß sein Durchstimmbereich dem Frequenzbereich von etwa 10 kHz bis 30 MHz
überdeckt.

12. Radio-Empfänger nach Anspruch 1, d a d u r c h
g e k e n n z e i c h n e t ,  daß der Empfänger im
Demodulationsteil für die Modulationsarten A1, A2H,
A3H, A3J und F1 eingerichtet ist.

13. Radio-Empfänger nach Anspruch 12, d a d u r c h
g e k e n n z e i c h n e t ,  daß die Demodulationsstufe weiterhin für die Modulationsarten A2 und A3A eingerichtet ist.

14. Radio-Empfänger nach Anspruch 1, d a d u r c h
g e k e n n z e i c h n e t ,  daß eine manuelle Einstellvorrichtung für die manuelle Auswahl eines der
Zwischenfrequenzfilter vorgesehen sind und daß diese
Filterauswahlvorrichtung bei der manuellen Betätigung
gegenüber den ersten Steuermitteln bevorrechtigt ist.

15. Radio-Empfänger nach Anspruch 1, d a d u r c h
g e k e n n z e i c h n e t ,  daß eine manuelle Einstellvorrichtung für die manuelle Auswahl einer der Demodulationsarten vorgesehen ist und diese Auswahl bei
der manuellen Betätigung gegenüber den ersten Steuermitteln bevorrechtigt ist.

16. Radio-Empfänger nach Anspruch 1, d a d u r c h
g e k e n n z e i c h n e t ,  daß eine erste manuell
bedienbare Einrichtung für die Auswahl eines der

Zwischenfrequenzfilter und eine zweite manuell betätigbare Vorrichtung für die manuelle Auwahl einer der Demodulationsarten vorgesehen ist und daß die ersten Steuermittel zur automatischen Auswahl eines der Zwischenfrequenzfilter und einer der Demodulationsarten vorgesehen sind, jedoch nicht für alle Frequenzen innerhalb des Empfängerdurchstimmbereichs.

17. Radio-Empfänger nach Anspruch 4, d a d u r c h g e k e n n z e i c h n e t , daß das örtliche Frequenzsignal eine Frequenz im Bereich von etwa 38 bis 68 MHz hat und der Mischer ein Differenzsignal von etwa 38 MHz erzeugt.

18. Radio-Empfänger nach Anspruch 4, d a d u r c h g e k e n n z e i c h n e t , daß der Frequenz-Synthesizer einen örtlichen Oszillator für die Erzeugung eines ersten Festfrequenzsignals und eine erste Phasenregelschleife enthält, der das erste Festfrequenzsignal zugeführt wird, woraus ein zweites Signal mit steuerbarer Frequenz gebildet wird und daß die erste Phasenregelschleife erste Frequenzvervielfacher/Frequenzteiler zur Frequenzvervielfachung/Frequenzteilung des zweiten Signals um einen ersten Faktor enthält und daß weiterhin die zweiten Steuermittel an die ersten Frequenzvervielfacher/Frequenzteiler zur Auswahl des ersten Faktors angeschaltet sind.

19. Radio-Empfänger nach Anspruch 18, d a d u r c h g e k e n n z e i c h n e t, daß der Frequenz-Synthesizer außerdem eine zweite Phasenregelschleife enthält, die zur Aufnahme des zweiten Signals vorgesehen ist und ein drittes Signal mit steuerbarer Frequenz erzeugt, und daß die zweite Phasenregelschleife zweite Frequenzvervielfacher/Frequenzteiler für die Frequenzvervielfachung/Frequenzteilung des dritten Signals durch einen zweiten Faktor umfaßt und daß weiterhin die zweite

Steuereinrichtung an diese zweite Frequenzvervielfacher /Frequenzteiler für die Auswahl eines dritten
Faktors angeschaltet sind.

20. Radio-Empfänger nach Anspruch 19, d a d u r c h
g e k e n n z e i c h n e t , daß die zweite Phasenregelschleife einen zweiten Mischer enthält, dem
das zweite Signal und das dritte Signal zugeführt werden
und der ein zweites Summen/Differenzsignal erzeugt.

21. Radio-Empfänger nach Anspruch 20, d a d u r c h
g e k e n n z e i c h n e t , daß die zweite Phasenregelschleife außerdem einen Phasendetektor für das
erste Signal und das dritte Signal enthält und der
ein Fehlersignal erzeugt, das repräsentativ für den
Phasenfehler zwischen dem ersten und dem dritten Signal
ist und daß ein spannungsgesteuerter Oszillator an
diesen Phasendetektor angeschaltet ist, der ein fünftes
Signal abgibt, dessen Frequenz von dem Fehlersignal
abhängig ist.

22. Radio-Sender mit einer Einrichtung für die Eingabe
einer spezifischen Frequenz für den Sendebetrieb innerhalb eines Radiofrequenzbereichs und mit einer Modulationseinrichtung für die spezifische Frequenz in
Übereinstimmung mit einer von einer Vielzahl von
Betriebsarten, d a d u r c h g e k e n n z e i c h -
n e t , daß eine Steuereinrichtung vorgesehen ist,
die der automatischen Auswahl der Modulationsart dient,
die bei der spezifischen Frequenz erforderlich ist.

23. Radio-Sender nach Anspruch 22, d a d u r c h
g e k e n n z e i c h n e t , daß die Steuereinrichtung einen Mikroprozessor enthält.

24. Radio-Sender nach Anspruch 22, d a d u r c h
g e k e n n z e i c h n e t , daß eine Signalquelle
für die Erzeugung eines Informationssignals, das für Aussendung bestimmt ist und ein Frequenz-Synthesizer für die Erzeugung eines gesteuerten örtlichen Frequenzsignals vorgesehen sind, und daß weiterhin die Modulationseinrichtung auf die Signalquelle und den Frequenz-Synthesizer für die Modulation des örtlichen Frequenzsignals mit dem Informationssignal anspricht und hierzu die Steuereinrichtung an den Frequenz-Synthesizer zur Auswahl der örtlichen Frequenz in Übereinstimmung mit der spezifischen Frequenz angekoppelt ist.

25. Radio-Sender nach Anspruch 22, d a d u r c h g e k e n n z e i c h n e t , daß als Betriebs- bzw. Modulationsarten alle Übertragungsarten für Sendungen in dem Durchstimmbereich vorgesehen sind.

26. Radio-Sender nach Anspruch 22, d a d u r c h g e k - e n n z e i c h n e t , daß der Durchstimmbereich des Senders den Frequenzbereich von etwa 1.605 MHz bis 30 MHz überdeckt.

27. Radio-Sender nach Anspruch 26, d a d u r c h g e k e n n z e i c h n e t , daß die Modulationseinrichtung als Betriebsarten die Modulationsarten A1, A3A, A3H, A3J und A7J umfaßt.

28. Radio-Sender nach Anspruch 22, d a d u r c h g e k e n n z e i c h n e t , daß eine manuell bedienbare Einrichtung für die manuelle Auswahl der Modulationsart vorgesehen ist, die bei der manuellen Betätigung gegenüber der Steuereinrichtung bevorrechtigt ist.

0033390

FIG. 1

FIG. 2A

LPF
30 MHz

RF FILTERS    IF FILTERS    DEMODULATION STAGE

DECODERS

SERIAL / PARALLEL REGISTER

CLOCK
STROBE
DATA

SYNTHESIZER 86

FIG. 2B

FIG. 3

4/9

0033390

FIG.4

```
                        ┌─────────┐
                        │  START  │
                        └─────────┘
                             │
                             ▼
   ┌─────────┐        ┌───────────────┐        ┌─────────┐
   │  S2182  │        │  SET STACK    │        │  S500   │
   └─────────┘        │  & TURN ALL   │        └─────────┘
        │             │  INDICATORS   │             │
        │             │     OFF       │             │
        │             └───────────────┘             │
        │                    │                       │
        │                    ▼                       ▼
        │             ┌───────────────┐      ┌───────────────┐
        └────────────►│  SET B-C-D    │      │  SET B-C-D    │
                      │  REGISTERS    │      │  REGISTERS    │
                      │  TO 021820    │      │  TO 005000    │
                      └───────────────┘      └───────────────┘
                             │                       │
                             ▼◄──────────────────────┘
                      ╱───────────────╲
                      │  B-C-D  TO     │
                      │  CURRENT       │
                      │  FREQ          │
                      ╲───────────────╱
                             │
                             ▼
                      ╱───────────────╲
                      │  B-C-D         │
                      │  TO            │
                      │  DISPLAY       │
                      ╲───────────────╱
                             │
                             ▼
                      ┌───────────────┐
                      │ SET CURRENT   │
                      │ MODE &BW=     │
                      │ A2H &WIDE     │
                      └───────────────┘
                             │
                             ▼
                      ╱───────────────╲
                      │ SET DISPLAY    │
                      │ A2H &          │
                      │ WIDE           │
                      ╲───────────────╱
                             │
                             ▼
                        ┌─────────┐
                        │  LOOP   │
                        └─────────┘
```

INITIALIZATION

FIG. 5

MAIN PROGRAM LOOP

FIG. 6A

MAIN PROGRAM LOOP

FIG.6B

FIG. 7

6/6

0033390

**Europäisches Patentamt**

# EUROPÄISCHER RECHERCHENBERICHT

## EINSCHLÄGIGE DOKUMENTE

| Kategorie | Kennzeichnung des Dokuments mit Angabe. soweit erforderlich. der maßgeblichen Teile | betrifft Anspruch |
|---|---|---|
| X | PHILIPS TELECOMMUNICATION REVIEW, Band 37, Nr. 1, März 1979, Seiten 1-10 Hilversum, NL. P. BIKKER et al.: "A microprocessor-controlled communications receiver" <br><br> * Seite 1, Zeile 1 - Seite 7, Zeile 12; Figuren 1-7 * <br><br> -- | 1-6,8-16 |
| X | WIRELESS WORLD, Band 83, Nr. 1504, Dezember 1977, Seite 86 London, G.B. "Synthesized communications receiver" <br><br> * Seite 86 * <br><br> -- | 1-6,8-16,18 |
| | SIEMENS-ZEITSCHRIFT, Band 49, Nr. 10, Oktober 1975, Seiten 638-644 Berlin, DE. C. KRAUSE et al.: "E403, ein fernbedienbarer Funkempfänger mit quasikontinuierlicher Abstimmung für den Frequenzbereich 10 kHz bis 30 MHz" <br><br> * Seite 638, rechte Spalte, Zeile 1 - Seite 641, rechte Spalte, Zeile 9; Figuren 1,2,4 * <br><br> -- | 1-6,8-16 |
| | ELECTRICAL COMMUNICATION, Band 48, Nr. 3, 1973, Seiten 269-274 London, G.B. K.G. BERG et al.: "Communications receiver series CR 300" <br><br> * Seite 270, linke Spalte, Zeile 9 - Seite 274, linke Spalte, Zeile 11; Figuren * <br><br> -- ./. | 1-6,8-16,18-21 |

**KLASSIFIKATION DER ANMELDUNG (Int Cl⁴)**

H 04 B 1/26
H 03 J 5/02
H 04 B 1/04

**RECHERCHIERTE SACHGEBIETE (Int Cl⁴)**

H 04 B 1/04
     1/16
     1/26
     1/28
H 03 J 5/02
H 03 L 7/22

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Grunden angeführtes Dokument
&: Mitglied der gleichen Patentfamilie. übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 30-03-1981 | MINNOYE |

| | EINSCHLÄGIGE DOKUMENTE | | KLASSIFIKATION DER ANMELDUNG (Int.Cl. ³) |
|---|---|---|---|
| Kategorie | Kennzeichnung des Dokuments mit Angabe, soweit erforderlich, der maßgeblichen Teile | betrifft Anspruch | |
| | DE - A - 1 964 912 (R.D. TOLLEFSON) <br><br> * Seite 4, Zeile 5 - Seite 8, Zeile 32; Figuren 1,2 * <br><br> -- <br><br> FR - A - 2 268 391 (N.V. PHILIPS GLOEILAMPENFABRIEKEN) <br><br> * Seite 25, Zeile 17 - Seite 10, Zeile 11; Figuren 4,5 * <br><br> & DE - A - 2 515 969 <br><br> -- <br><br> DE - A - 2 727 335 (B. BLUTHGEN) <br><br> * Ansprüche 1,2 * <br><br> ---- | 18-21 <br><br><br><br><br> 18-21 <br><br><br><br><br><br><br><br> 1,3, 22,23 | **RECHERCHIERTE SACHGEBIETE (Int. Cl. ³)** |